(19) Europäisches Patentamt
European Patent Office
Office européen des brevets

(11) Veröffentlichungsnummer: **0 468 185 A2**

# (12) EUROPÄISCHE PATENTANMELDUNG

(21) Anmeldenummer: **91109677.4**

(51) Int. Cl.[5]: **G03F 7/32**

(22) Anmeldetag: **13.06.91**

(30) Priorität: **27.06.90 DE 4020372**

(43) Veröffentlichungstag der Anmeldung:
**29.01.92 Patentblatt 92/05**

(84) Benannte Vertragsstaaten:
**BE CH DE FR GB IT LI NL SE**

(71) Anmelder: **BASF Aktiengesellschaft**
**Carl-Bosch-Strasse 38**
**W-6700 Ludwigshafen(DE)**

(72) Erfinder: **Bach, Helmut, Dr.**
**Richard-Wagner-Strasse 12**
**W-6702 Bad Duerkheim(DE)**
Erfinder: **Telser, Thomas, Dr.**
**Langer Wiesenweg 13**
**W-6940 Weinheim(DE)**
Erfinder: **Dietz, Gernot**
**Brucknerstrasse 12**
**W-6719 Eisenberg(DE)**

## (54) Verfahren zur Herstellung photopolymerer flexographischer Reliefdruckplatten.

(57) Bei einem neuen, verbesserten Verfahren zur Herstellung photopolymerer flexographischer Reliefdruckplatten aus lichtempfindlichen Aufzeichnungselementen, welche

A) einen dimensionsstabilen Träger und

B) mindestens eine photopolymerisierbare Aufzeichnungsschicht mit

$b_1$) mindestens einem elastomeren Polymeren als Bindemittel,

$b_2$) mindestens einem photopolymerisierbaren Monomeren, welches mit dem Bindemittel ($b_1$) verträglich ist, und

$b_3$) mindestens einem Photopolymerisationsinitiator

enthalten, durch

(1) bildmäßiges Belichten der photopolymerisierbaren Aufzeichnungsschicht (B) mit aktinischem Licht und

(2) Auswaschen (Entwickeln) der nicht belichteten und daher nicht photopolymerisierten Bereiche der bildmäßig belichteten Aufzeichnungs-Schicht (B) mit einem organischen Entwicklerlösungsmittel unter Bildung einer Reliefschicht,

werden als organische Entwicklerlösungsmittel Essigsäure-(3-methoxy-n-butyl)-ester und/oder Glykolsäure-n-butylester verwendet.

EP 0 468 185 A2

Die vorliegende Erfindung betrifft ein verbessertes Verfahren zur Herstellung photopolymerer flexographischer Reliefdruckplatten aus lichtempfindlichen Aufzeichnungselementen, welche

A) einen dimensionsstabilen Träger und

B) mindestens eine photopolymerisierbare Aufzeichnungsschicht mit

$b_1$) mindestens einem elastomeren Polymeren als Bindemittel,

$b_2$) mindestens einem photopolymerisierbaren Monomeren, welches mit dem Bindemittel ($b_1$) verträglich ist, und

$b_3$) mindestens einem Photopolymerisationsinitiator

enthält, durch

(1) bildmäßiges Belichten der photopolymerisierbaren lichtempfindlichen Aufzeichnungsschicht (B) mit aktinischem Licht und

(2) Auswaschen (Entwickeln) der nicht belichteten und daher nicht photopolymerisierten Bereiche der bildmäßig belichteten Aufzeichnungsschicht (B) mit einem organischen Entwicklerlösungsmittel unter Bildung einer Reliefschicht.

Ein solches Verfahren ist, sieht man von der erfindungsgemäßen Verbesserung ab, allgemein bekannt. üblicherweise sind dabei stets als Entwicklerlösungsmittel

(i) chlorierte Kohlenwasserstoffe wie Chloroform, Trichlorethylen, Tetrachlorethylen oder Trichlorethan als solche oder als Gemische mit niederen Alkoholen wie n-Butanol;

(ii) gesättigte cyclische und acyclische Kohlenwasserstoffe wie Petrolether, Hexan, Heptan, Octan, Cyclohexan oder Methylcyclohexan;

(iii) aromatische Kohlenwasserstoffe wie Benzol, Toluol oder Xylol; oder

(iv) niedere aliphatische Ketone wie Aceton, Methylethylketon oder Methylisobutylketon verwendet worden.

Für diese bekannten Verfahrensweisen ist es stets nachteilig gewesen, daß man die Entwicklerlösungsmittel hat lange einwirken lassen müssen, um eine befriedigende Auswaschwirkung zu erzielen. Dabei sind die Reliefschichten häufig angequollen worden, oder Teile des Reliefs sind unterwaschen und unter Umständen mechanisch abgelöst worden. Außerdem sind bei der Verwendung üblicher gesättigter oder aromatischer Kohlenwasserstoffe und Ketone lange Trocknungszeiten notwendig gewesen, und häufig ist es dabei zu der gefürchteten "positiven inneren Zurichtung" gekommen, d.h. die feineren Bildelemente haben über das Niveau von Volltonflächen herausgeragt. Nicht zuletzt weisen diese Entwicklerlösungsmittel bis auf die chlorierten Kohlenwasserstoffe niedrige Flammpunkte von kleiner als 21 °C auf, was die Verwendung besonderer explosionsgeschützter Anlagen zur Durchführung des Verfahrens notwendig gemacht hat. Andererseits ist es bei der Verwendung chlorierter Kohlenwasserstoffe wegen ihrer Toxizität zu Entsorgungsproblemen gekommen. Zwar weisen diese Entwicklerlösungsmittel ein vorzügliches Lösevermögen auf, indes haben die photopolymeren flexographischen Reliefdruckplatten, welche mit Hilfe dieser Entwicklerlösungsmittel hergestellt worden sind, einen unbefriedigenden Flankenaufbau und eine auffallende, runzelige Oberflächenstruktur, die sogenannte Orangenhaut, aufgewiesen.

Inzwischen sind aber die Ansprüche, welche an das anwendungstechnische Eigenschaftsprofil photopolymerer flexographischer Reliefdruckplatten in der Praxis gestellt werden, stetig weiter gewachsen. So erwartet man heutzutage von photopolymeren flexographischen Reliefdruckplatten, daß sie sich in besonders einfacher, umweltschonender, zuverlässiger Weise aus lichtempfindlichen Aufzeichnungselementen herstellen lassen, nach ihrer Herstellung die Bildvorlage vollkommen detailgetreu wiedergeben, ozonresistent sind, keine klebrige Oberfläche aufweisen, unter Druckbedingungen gegenüber den Lösungsmitteln der üblicherweise verwendeten Flexodruckfarben beständig sind und exzellente Druckerzeugnisse in besonders hoher Auflage liefern. Dieses Anforderungsprofil ist nicht nur von der stofflichen Zusammensetzung der jeweils verwendeten lichtempfindlichen Aufzeichnungselemente abhängig, sondern auch von der Art und Weise ihrer Weiterverarbeitung zu photopolymeren flexographischen Reliefdruckplatten. Es besteht daher der Zwang, die bislang bekannten Verfahrensweisen immer weiter zu entwickeln, um mit den stetig anwachsenden Ansprüchen der Praxis Schritt halten zu können.

So ist aus der EP-A-0 228 676 (US-A-4 806 452) ein Verfahrens der eingangs genannten Art bekannt, bei welchem man verzweigte oder unverzweigte, einfach bis dreifach olefinisch ungesättigte acyclische Kohlenwasserstoffe, Alkohole oder Ketone mit 8 bis 15 Kohlenstoffatomen und/oder gesättigte oder einfach bis dreifach olefinisch ungesättigte cyclische aliphatische Kohlenwasserstoffe, Alkohole oder Ketone mit 8 bis 15 Kohlenstoffatomen im Molekül als wesentliche Bestandteile der organischen Entwicklerlösungsmittel verwendet. Dabei werden als Beispiele geeigneter Kohlenwasserstoffe, Alkohole oder Ketone mit 8 bis 15 Kohlenstoffatomen 1-Octen, Cyclooctan, Cycloocten, Cyclooctanol, Cyclooctanon, 3-Nonen, Mono- und Sesquiterpene oder Terpentinöle genannt. Von diesen werden die Monoterpene wie beispielsweise p-Menthan, Borneol, Menthon, D- und L-Limonen, $\alpha$-Terpineol, $\alpha$-Terpinen, $\gamma$-Terpinen, Terpinolen, $\alpha$-Pinen, $\beta$-

Pinen, δ-Pinen und Citronellol als vorteilhaft bezeichnet. Die organischen Entwicklerlösungsmittel, welche mindestens eine dieser Verbindungen, insbesondere aber Limonen, enthalten, können, bezogen auf ihre Gesamtmenge etwa bis zu 40 Gew.-% an anderen Lösungsmitteln enthalten. Hierbei sollen die vom vorstehend angegebenen Stand der Technik her bekannten, insbesondere aber höhersiedende Alkohole in einer Menge von 20 Gew.-% in Betracht kommen.

Zwar kann dieses bekannte Verfahren in nicht explosionsgeschützten Waschern durchgeführt werden und liefert dabei gute bis sehr gute photopolymere flexographische Reliefdruckplatten, indes weisen die bei diesem Verfahren verwendeten organischen Entwicklerlösungsmittel einen so intensiven Eigengeruch auf, daß die Durchführung des Verfahrens nur in besonders intensiv belüfteten Fabrikräumen möglich ist, was einen schwerwiegenden Nachteil darstellt.

Hier hat das aus der EP-A-0 332 070 bekannte Verfahren der eingangs genannten Art einen gewissen Fortschritt mit sich gebracht. Bei diesen bekannten Verfahren werden als organische Entwicklerlösungsmittel hydrierte Erdölfraktionen eines Siedebereiches zwischen 160 und 220 °C und eines Flammpunktes von über 45 °C verwendet. Diese hydrierten Erdölfraktionen sollen einen Aromatengehalt von kleiner 1 % und einen Anteil an naphthenischen Kohlenwasserstoffen zwischen 0,5 und 50 % aufweisen. Solche Produkte sind üblich und bekannt und werden beispielsweise von der Firma Exxon unter den Markennamen "Exxsol D", Nappar", "Norpar" oder "Isopar", von der Firma Esso, unter dem Handelsnamen oder Warenzeichen "Shellsol D" oder von der Firma Hydrocarbures unter dem Handelsnamen oder Warenzeichen "Hydrosol P" vertrieben.

Diese Entwicklerlösungsmittel sollen außerdem Alkohole mit einer Kohlenstoffanzahl von 4 bis 8 wie n-Butanol, n-Pentanol, Isobutanol oder Hexanol enthalten können. Dabei soll der Anteil mindestens 5 Vol.%, vorzugsweise 20 Vol.% betragen. Darüber hinaus sollen diesem bekannten organischen Entwicklerlösungsmittel noch oberflächenaktive Substanzen in einer Menge von bis zu 2 Gew.-% oder geruchsverbessernde Zusatzstoffe wie Limonen, Pinen oder Citronellol in einer Menge von bis zu 10 Gew.-% zugegeben werden können. Zwar wirft dieses bekannte Verfahren keine so schwerwiegenden Geruchsprobleme auf wie das aus der EP-A-0 228 676 bekannte und liefert auch gute bis sehr gute photopolymere flexographische Reliefdruckplatten, welche eine hervorragende Oberfläche, keine Orangenhaut und - wenn überhaupt - nur eine geringe Quellung aufweisen, indes hat die Verwendung dieser Entwicklerlösungsmittel relativ lange Auswaschzeiten zur Folge, was besonders nachteilig beim Auswaschen dicker Druckplatten ist, und es resultieren lange Trocknungszeiten, was in der betrieblichen Praxis nicht akzeptabel ist. Des weiteren kann es unter gewissen Umständen zur Bildung sogenannter Tropfnasen auf der Oberfläche der photopolymeren flexographischen Reliefdruckplatten kommen, welche von nicht gelösten oder wieder ausgefallenen Polymerresten hervorgerufen werden.

Aus der US-A-4 847 182 ist eine Variante des Verfahrens bekannt, welches aus der EP-A-0 228 676 hervorgeht. Bei dieser Verfahrensvariante werden den in der Hauptsache aus Terpenen bestehenden organischen Entwicklerlösungsmitteln sogenannte "Nicht-Lösungsmittel" wie n-Butanol, 2-Ethoxyethanol, Benzylalkohol, Ethanol, 2-Butoxyethanol, Isopropylalkohol, 2-(2-Butoxyethoxy)-ethanol, Mineralöl, "mineral spirits", Ligroin, Decan oder Octan zugesetzt. Diese Nicht-Lösungsmittel sollen das Ausfallen der ausgewaschenen Materialien aus dem jeweils verwendeten organischen Entwicklerlösungsmittel bewirken, so daß dessen Aufarbeitung vereinfacht wird. Des weiteren wird empfohlen, die Terpene und die "Nicht-Lösungsmittel" in der Form wäßriger Emulsionen zu verwenden. Wie aus den Beispielen der US-A-4 847 182 weiter hervorgeht, müssen dabei große Mengen an oberflächenaktiven Substanzen mitverwendet werden. Abgesehen davon, daß dieses Verfahren nicht die Probleme zu lösen vermag, welche mit dem intensiven Geruch der hierbei verwendeten Terpene verbunden sind, bereitet die Herstellung der Emulsionen in der Praxis häufig große Schwierigkeiten, weil sie sehr stark zum Schäumen neigen.

Aus der EP-A-0 355 789 ist ein Verfahren bekannt, für welches die organischen Entwicklerlösungsmittel aus den folgenden Verbindungsklassen ausgewählt werden:

(i) Diethylenglykoldialkylether mit Alkylgruppen, welche 1 bis 5 Kohlenstoffatome enthalten;

(ii) Essigsäureester von gesättigten, 6 bis 10 Kohlenstoffatome enthaltenden Alkoholen oder von 6 bis 10 Kohlenstoffatome enthaltenden, alkoxysubstituierten gesättigten Alkoholen;

(iii) Carbonsäureester von 6 bis 10 Kohlenstoffatome enthaltenden Carbonsäuren und 1 bis 6 Kohlenstoffatome enthaltenden Alkoholen sowie

(iv) Ester von 2 bis 4 Kohlenstoffatome enthaltenden, alkoxysubstituierten Carbonsäuren, worin der Alkoxyrest 1 bis 4 Kohlenstoffatome aufweist, und einem 1 bis 4 Kohlenstoffatome enthaltenden Alkohol.

Hiervon sollen Diethylenglykoldiethylether, Essigsäure-3,5,5-trimethylhexylester, Essigsäure-(2-butoxyethyl)-ester (Butylglykolacetat), Essigsäure-2-ethylbutylester, Essigsäure-2-cyclohexylethylester, Essigsäure-2-ethylhexylester oder Mischungen hiervon, Octansäureethylester, Hexansäure-2-pentylester, Nonansäureethylester oder 3-Ethoxypropionsäureethylester vorteilhaft sein. Von diesen wiederum sollen 3-Ethoxypropionsäureethylester, Gemische aus Essigsäurenonylestern, Essigsäure-2-ethylhexylester und Diethylenglykoldiethylether, oder Gemische aus Essigsäure-3,5,5-trimethylhexylester, Essigsäure-2-ethylhexylester und Diethylenglykoldiethylether besonders bevorzugt verwendbar sein. Außerdem sollen diese organischen Entwicklerlösungsmittel noch 5 bis 40 Volumen- oder Gewichtsprozent, welches hiervon zutrifft bleibt offen, an Alkoholen wie Butanol, Benzylalkohol oder 2-Ethylhexanol enthalten.

In der betrieblichen Praxis ist die Verwendung der Alkylester als organische Entwicklerlösungsmittel von großem Nachteil, weil jeder Vertreter dieser Verbindungsklasse den für ihn jeweils typischen intensiven Estergeruch aufweist. Dieser intensive Geruch führt zu schwerwiegenden Beeinträchtigungen des Personals im reprographischen Betrieb, welches den schon fast sprichwörtlich intensiven Estergeruch nach einer gewissen Zeit nachgerade als unerträglich empfindet. Ein weiterer Nachteil des aus der EP-A-0 355 789 bekannten Verfahrens ist, daß die hierbei verwendeten organischen Entwicklerlösungsmittel eine sehr starke Quellung der entwickelten bildmäßig belichteten Aufzeichnungsschichten bewirken und die in hohem Maße unerwünschte Orangenhaut auf der druckenden Oberfläche der photopolymeren flexographischen Reliefdruckplatten hervorrufen.

Im Vergleich mit den Alkylestern ist der Essigsäure-(2-butoxyethyl)-ester als weitgehend geruchsfrei zu bezeichnen. Nachteilig für diesen Ester ist aber, daß sein Löse- oder Dispergiervermögen unbefriedigend ist und somit zu vergleichsweise langen Auswaschzeiten führt, die Trocknungszeiten vergleichsweise lang sind und daß er stark hautreizend wirkt, ein Problem, das durch die besonders leichte Aufnahme des Esters durch die menschliche Haut noch verschlimmert wird. Für die Handhabung des Essigsäure-(2-butoxyethyl)-esters in größeren Mengen sind daher im reprographischen Betrieb besondere Vorsichtsmaßnahmen zu treffen, um das Personal nicht zu exponieren. Diese Nachteile werden denn auch nicht durch den schwachen Geruch dieses Esters kompensiert.

Nachteile dieser Art treten auch bei dem aus der DE-A-38 36 402 bekannten Verfahren auf, bei welchem Ester der allgemeinen Formel I verwendet werden sollen

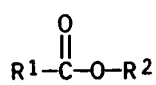

(I),

worin $R^1$ und $R^2$ gleich oder verschieden sein können und n- oder iso-Alkylreste mit 1 bis 13 Kohlenstoffatomen, Cycloalkylreste mit 5, 6 oder 12 Kohlenstoffatomen, Alkylarylreste mit 1 bis 3 Kohlenstoffatomen im Alkylrest und 6 Kohlenstoffatomen im Arylrest oder Arylreste mit 6 oder 10 Kohlenstoffatomen bezeichnen, wobei die Summe der Kohlenstoffatome in den Resten $R^1$ und $R^2$ 6 bis 13 beträgt. Hierbei sollen vor allem Essigsäure-amyl, Essigsäure-i-amyl-, Essigsäure-hexyl-, Essigsäure-cyclohexyl-, Essigsäure-ethylhexyl-, Essigsäure-nonyl-, Essigsäure-i-nonyl-, Propionsäure-propyl-, Buttersäure-propyl, Buttersäure-butyl-, Buttersäure-i-butyl, Essigsäure-benzyl- oder Benzoesäure-methylester verwendet werden - allesamt Verbindungen mit mehr oder weniger intensivem Geruch.

Weitere Verfahren sind aus der DE-A-38 36 404 und der DE-A-38 36 403 bekannt.

Bei dem Verfahren der DE-A-38 36 404 sollen Phenolether der allgemeinen Formel II verwendet werden

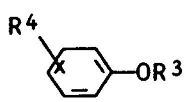

(II),

worin $R^3$ einen n- oder iso-Alkylrest mit 1 bis 6 Kohlenstoffatomen, einen Cycloalkylrest oder einen Arylrest mit 6 bis 12 Kohlenstoffatomen und $R^4$ ein Wasserstoffatom oder einen n- oder iso-Alkylrest mit 1 bis 6 Kohlenstoffatomen oder einen Rest $-OR^3$ bezeichnet. Hiervon sollen Methylphenyl-, Ethylphenyl-, Isopropylphenyl-, Propylphenyl-, o-Kresylmethyl-, m-Kresylmethyl-, p-Kresylmethy-, Resorcindimethyl- und Brenzkatechinethylether vorteilhaft sein. Demgegenüber macht das Verfahren der DE-A-38 36 403 von Aromaten der allgemeinen Formel III Gebrauch

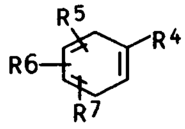

(III),

worin $R^4$ bis $R^7$ gleich oder verschieden sein können und Wasserstoffatome oder n- oder iso-Alkylreste mit 1 bis 5 Kohlenstoffatomen bedeuten, wobei $R^4$ und $R^5$, sofern sie direkt benachbart sind, auch einen cycloaliphatischen Ring mit 5 bis 6 Ringkohlenstoffatomen ausbilden können, wobei letztere vorzugsweise nicht substituiert sind und wobei die Summe der Kohlenstoffatome der Substituenten und der Ringglieder 9 bis 13 ist. Hiervon sollen vor allem Isopropylbenzol, n-Propylbenzol, 1-Methyl-3-ethylbenzol, 1,3,5-Trimethylbenzol, 1-Methyl-2-ethylbenzol, 1,2,4-Trimethylbenzol, Isobutylbenzol, sec.-Butylbenzol, 1,2,3-Trimethylbenzol, 1-Methyl-4-isopropylbenzol, Indan, Inden, 1,3-Diethylbenzol, 1-Methyl-4-propylbenzol, n-Butylbenzol, 1-Methyl-3-propylbenzol, 1,2,4,5-Tetramethylbenzol, Dimethylethylbenzol, Methylindan oder n-Pentylbenzol angewandt werden.

Diese beiden Verfahren machen zwar von Verbindungen Gebrauch, welche nicht ganz so intensiv wie die Ester, dafür aber zum Teil recht unangenehm riechen. Dadurch kann, allerdings nur graduell, die besonders intensive Geruchsbelästigung durch die Ester gemildert werden. Es verbleibt jedoch der schwerwiegende Nachteil, daß es sich bei den Entwicklerlösungsmitteln der DE-A-38 36 404 und der DE-A-38 36 403 ausschließlich um aromatische Lösungsmittel handelt, welche letztlich allesamt mehr oder weniger große toxikologische, arbeitshygienische, sicherheitstechnische und ökologische Probleme aufwerfen.

Weitere Nachteile werden bei der Berücksichtigung des folgenden technischen Sachverhaltes deutlich:

Während des Auswaschens (Entwickelns) der bildmäßig belichteten Aufzeichnungsschichten (B) nehmen die belichteten und daher photoplymerisierten Bereiche der Aufzeichnungsschicht (B) Lösungsmittel auf. Dieser Vorgang wird üblicherweise als Quellung bezeichnet. Das Ausmaß der Quellung kann durch die separate Bestimmung der Schichtdickenzunahme und/oder der Gewichtszunahme der vollständig belichteten und hiernach mit dem betreffenden Entwicklerlösungsmittel behandelten Aufzeichnungsschicht (B) quantifiziert werden. Im allgemeinen liegt in der Praxis die Quellung der bildmäßig belichteten und entwickelten Aufzeichnungsschichten (B), sprich der Reliefschichten, der photopolymeren flexographischen Reliefdruckplatten bei 5 bis 10 Gew.-%. In Schichtdicken umgerechnet, bedeutet dies beispielsweise bei einer 3 mm dicken lichtempfindlichen Aufzeichnungsschicht (B) bzw. bei der hieraus hergestellten Reliefschicht eine Schichtdickenzunahme von 150 bis 300 $\mu$m.

Durch die Trocknung soll nun das von der Reliefschicht der photopolymeren flexographischen Reliefdruckplatte aufgenommene organische Entwicklerlösungsmittel wieder entfernt werden. Hierbei wird in der Praxis oft der Fehler begangen, die Trocknung ganz zu beenden, wenn die photopolymere flexographische Reliefdruckplatte, bzw. deren Reliefschicht ihre Ausgangsdicke oder ihr Ausgangsgewicht wieder erreicht hat. Dabei wird übersehen, daß die ursprüngliche bildmäßig belichtete Aufzeichnungsschicht (B) während des Auswaschens (Entwickeln) nicht nur organische Entwicklerlösungsmittel aufnimmt, sondern auch niedermolekulare Bestandteile wie z.B. Weichmacher oder andere Hilfsstoffe gegen das organische Entwicklerlösungsmittel austauscht. Es findet somit gleichzeitig eine Quellung und eine Extraktion statt, was dazu führt, daß die üblicherweise angeführten Quellwerte nicht die Quellung als solche wiedergeben, sondern in Wirklichkeit die Summe aus Quellung und Extraktion darstellen.

Wird nun bei dem in Rede stehenden Verfahren ein organisches Lösungsmittel verwendet, bei welchem der Effekt der Extraktion besonders stark ausgeprägt ist, und werden die hiermit entwickelten photopolymeren flexographischen Reliefdruckplatten bis zur tatsächlichen Gewichts- oder Dickenkonstanz getrocknet, was im allgemeinen mehrere Tage erfordert, so wird das Ausgangsgewicht bzw. die Ausgangsschichtdicke der Reliefschicht der photoplymeren Reliefdruckplatte deutlich unterschritten.

Werden dagegen der üblichen Verfahrensweise entsprechend die photopolymeren flexographischen Reliefdruckplatten nur bis zum Erreichen des Ausgangsgewichts oder der Ausgangsschichtdicke getrocknet, dann enthalten ihre Reliefschichten notwendigerweise noch hohe Anteile an organischen Lösungsmitteln. Diese Restlösungsmittel sind aber in den Reliefschichten ungleichmäßig verteilt. So weisen feine Strukturen wie z.B. Raster mit einer großen Oberfläche pro Volumen erheblich höhere Quellwerte auf als Volltonflächen. Dies gilt auch für die Ränder von diesen Volltonflächen, welche stärker angequellen als deren Mitte. Dies hat zur Folge, daß die feinen Strukturen und die Ränder der Volltonflächen in der Reliefschicht der photopolymeren flexographischen Reliefdruckplatten höher stehen als beispielsweise die Mitte der Volltonflächen. Diese Inhomogenitäten und unterschiedlichen Höhen (Toleranzen) werden vor allem durch die stets vorhandene ungleichmäßige Temperaturverteilung im Trockner mit hervorgerufen und verstärkt. Nehmen diese Toleranzen in einer photopolymeren flexographischen Reliefdruckplatte überhand, bewirken sie deren Unbrauchbarkeit.

Selbst wenn die Menge des noch vorhandenen Restlösungsmittels nicht unmittelbar zur Unbrauchbarkeit der betreffenden photopolymeren flexographischen Reliefdruckplatte führt, bewirkt es immer noch den sogenannten Langzeitschrumpf, d.h. die Reliefschicht der betreffenden photopolymeren flexographischen Reliefdruckplatte verändert durch das Verdunsten des Restlösungsmittels bei längerer Lagerung oder

längerem Gebrauch ihre Dimensionen. Wegen des Langzeitschrumpfes erhält man dann mit ein und derselben Platte nach längerer Lager- oder Gebrauchsdauer unterschiedliche Druckergebnisse, was für die Praxis nicht akzeptabel ist.

Dieser Nachteil wird in der Praxis insbesondere dann akut, wenn nach längerer Gebrauchsdauer eine der vier photopolymeren flexographischen Reliefdruckplatten eines flexographischen Vierfarbensatzes nicht mehr mitverwendet werden kann und von jetzt auf nachher durch eine neu herzustellende, im Motiv und in ihrer Dimension identische Reliefdruckplatte ersetzt werden muß, welche den betreffenden Farbauszug zu den anderen drei Farbauszügen exakt passend druckt. Ein solcher rascher Ersatz ist aber nicht mehr möglich, wenn die photopolymeren flexographischen Reliefdruckplatten des Vierfarbensatzes einen Langzeitschrumpf erlitten haben, weil dann die neu hergestellte Reliefdruckplatte in ihren Dimensionen nicht mehr zu den übrigen drei paßt. Ist dies der Fall, bleibt nur noch der zeitraubende und teure Ausweg, alle vier Reliefdruckplatten des Vierfarbensatzes neu herzustellen.

Abgesehen davon, daß es in hohem Maße wünschenswert ist, die Nachteile der bislang bekannten Verfahren der eingangs genannten Art durch Variation ihrer Parameter, insbesondere der organischen Entwicklerlösungsmittel, zu vermindern oder gar ganz zu beseitigen, müssen bei der Erfolgskontrolle auch noch andere Meßmethoden angewandt werden. So sollte sich die notwendige Dauer der Trocknung nicht nach dem Erreichen der Ausgangsschichtdicke oder des Ausgangsschichtgewichts richten, sondern danach, wann die Toleranzen der Reliefschichten der photopolymeren Reliefdruckplatten einen Minimalwert erreicht haben, wobei die Angabe der Toleranzen noch durch eine Flächenangabe und die Angabe der Zahl der Meßstellen auf der Reliefschicht zu ergänzen wäre. Diese Angaben spezifizierten in ihrer Gesamtheit eine Trocknungszeit, bei welcher die Menge an Restlösungsmittel in der photopolymeren flexographischen Reliefdruckplatte einen Wert erreicht hätte, welcher die Brauchbarkeit der Druckplatte unter Praxisbedingungen nicht mehr länger verminderte oder gar vollständig zunichte machte. Ohne solche detaillierten Angaben kann keine Erfolgskontrolle durchgeführt werden, und eine Vergleichbarkeit von organischen Entwicklerlösungsmitteln untereinander ist nicht gewährleistet.

Ansonsten werden in den beiden älteren nicht vorveröffentlichten deutschen Patentanmeldungen P 3908764.6 und P 3908763.8 Verfahren der eingangs genannten Art beschrieben, bei welchen Emulsionen aus organischen Entwicklerlösungsmitteln und Wasser verwendet werden. Hierbei kommen als organische Entwicklerlösungsmittel chlorierte Kohlenwasserstoffe, gesättigte und/oder ungesättigte cyclische Kohlenwasserstoffe, gesättigte und/oder ungesättigte acyclische Kohlenwasserstoffe, Petroleumdestillate, hydrierte Erdölfraktionen und/oder deren Gemische in Betracht, sofern sie jeweils für sich selbst gesehen bereits nichtbrennbar, schwerbrennbar und/oder hochsiedend sind. Außerdem kommen Gemische langkettiger Alkylester mit Alkylgruppen unterschiedlicher Kettenlänge, welche indes nicht näher spezifiziert werden, in Betracht. Diese Emulsionen können außerdem noch 0,1 bis 20 Vol.% mindestens eines Alkohols wie etwa n-Butanol, n-Pentanol, n-Hexanol, Cyclohexanol, n-Heptanol, n-Octanol, n-Decanol, Laurylalkohol, 3-Methyl-3-methoxybutanol, Benzylalkohol oder 2,3,5-Trimethylhexanol enthalten.

Aufgabe der vorliegenden Erfindung ist es, das eingangs genannte Verfahren weiter zu entwickeln, um so zu einem neuen, verbesserten Verfahren zur Herstellung einer flexographischen Reliefdruckplatte aus einem lichtempfindlichen Aufzeichnungselement zu gelangen, welches die vorstehend genannten Nachteile des Standes der Technik - auch unter Berücksichtigung exakter Vergleichskriterien - nicht mehr länger aufweist.

Zur Lösung dieser Aufgabe hat die überraschende Erkenntnis beigetragen, daß die Verwendung zweier speziell ausgewählter Lösungsmittel die Nachteile der bislang bekannten Verfahren beseitigen kann.

Gegenstand der vorliegenden Erfindung ist demnach ein neues, verbessertes Verfahren zur Herstellung einer photopolymeren flexographischen Reliefdruckplatte aus einem lichtempfindlichen Aufzeichnungselement, welches

A) einen dimensionsstabilen Träger und

B) mindestens eine photopolymerisierbare Aufzeichnungsschicht mit

$b_1$) mindestens einem elastomeren Polymeren als Bindemittel,

$b_2$) mindestens einem photopolymerisierbaren Monomeren, welches mit dem Bindemittel ($b_1$) verträglich ist und

$b_3$) mindestens einem Photopolymerisationsinitiator

enthält, durch

(1) bildmäßiges Belichten der photopolymerisierbaren Aufzeichnungsschicht (B) mit aktinischem Licht und

(2) Auswaschen (Entwickeln) der nicht belichteten und daher nicht photopolymerisierten Bereiche der bildmäßig belichteten Aufzeichnungsschicht (B) mit einem organischen Entwicklerlösungsmittel unter Bildung einer Reliefschicht,

wobei das Verfahren dadurch gekennzeichnet ist, daß das organische Entwicklerlösungsmittel Essigsäure-(3-methoxy-n-butyl)-ester und/oder Glykolsäure-n-butylester enthält oder hieraus besteht.

Im folgenden wird das neue, verbesserte Verfahren zur Herstellung einer photopolymeren flexographischen Reliefdruckplatte aus einem lichtempfindlichen Aufzeichnungselement der Kürze halber als "erfindungsgemäßes Verfahren" bezeichnet.

Im Rahmen der vorliegenden Erfindung wird unter "verträglich" die Eigenschaft mehrerer Komponenten verstanden, miteinander vollständig mischbar zu sein und sich auch nach längerer Lagerungszeit nicht wieder zu entmischen.

Wesentlich für die Durchführung des erfindungsgemäßen Verfahrens ist das organische Entwicklerlösungsmittel. Dieses enthält entweder Essigsäure-(3-methoxy-n-butyl)-ester oder Glykolsäure-n-butylester. Zwar können diese beiden organischen Entwicklerlösungsmittel gemeinsam verwendet werden, indes wird ihrer Einzelanwendung der Vorzug gegeben.

Erfindungsgemäß ist es von Vorteil, wenn das organische Entwicklerlösungsmittel, welches bei dem erfindungsgemäßen Verfahren angewandt wird, in der Hauptsache aus Essigsäure-(3-methoxy-n-butyl)-ester oder Glykolsäure-n-butylester besteht, d.h., daß jeweils eine dieser beiden Verbindungen in einem Anteil von mehr als 50, vorteilhafterweise 70 und insbesondere 80 Vol.-% in dem jeweils verwendeten organischen Entwicklerlösungsmittel enthalten ist. Es kann indes auch von Vorteil sein, wenn das organische Entwicklerlösungsmittel entweder aus Essigsäure-(3-methoxy-n-butyl)-esteroder aus Glykolsäure-n-butylester besteht.

Das erfindungsgemäße organische Entwicklerlösungsmittel kann darüber hinaus auch noch Alkohole enthalten. Der Zusatz des Alkohols hat den Zweck, eine gegebenenfalls der photopolymerisierbaren Aufzeichnungsschicht (B) des lichtempfindlichen Aufzeichnungselements direkt aufliegende, alkohollösliche Deckschicht (C) in dem jeweils verwendeten organischen Entwicklerlösungsmittel löslich zu machen. Zwar könnte man zu diesem Zweck die besagte Deckschicht (C) durch einen gesonderten Auswaschschritt mit einem Alkohol wegwaschen, indes machte dies einen zusätzlichen Verfahrensschritt notwendig, weswegen bei dem Vorhandensein einer Deckschicht (C) der Zugabe eines Alkohols zu dem organischen Entwicklerlösungsmittel der Vorzug gegeben wird.

Hierbei ist es für das erfindungsgemäße Verfahren von Vorteil, wenn der oder die Alkohole in einem Anteil von 0,1 bis 30 Vol.-% in den erfindungsgemäß zu verwendenden organischen Entwicklerlösungsmitteln enthalten sind. Von ganz besonderem Vorteil ist es, wenn der betreffende Alkohol in seinem Siedepunkt oder seinem Siedebereich dem Siedepunkt oder Siedebereich des erfindungsgemäß zu verwendenden organischen Entwicklerlösungsmittels angepaßt ist.

Beispiel besonders gut geeigneter Alkohole, welche für den erfindungsgemäßen Verwendungszweck in Betracht kommen, sind Benzylalkohol, Isoheptanol, Isooctanol, Isononanol, 3,5,5-Trimethylhexanol, 2-Ethylhexanol und die technischen Alkoholgemische, welche von der Firma Exxon unter den Handelsnamen oder Warenzeichen Exxal 7, 8 und 9 vertrieben werden.

Nach ihrer erfindungsgemäßen Verwendung können die Essigsäure-(3-methoxy-n-butyl)-ester und/oder Glykolsäure-n-butylester enthaltenden oder hieraus bestehenden organischen Entwicklerlösungsmittel in vorteilhaft einfacher Weise durch Destillation wieder aufgearbeitet und erneut für das erfindungsgemäße Verfahren verwendet werden. Hierbei können vor allem die Essigsäure-(3-methoxy-n-butyl)-ester enthaltenden Entwicklerlösungsmittel oder der Ester selbst unter Normaldruck destilliert werden.

Methodisch bietet das erfindungsgemäße Verfahren keine Besonderheiten, d.h., man entwickelt die in üblicher Weise bildmäßig belichteten Aufzeichnungsschichten (B) der lichtempfindlichen Aufzeichnungselemente durch Auswaschen der nicht belichteten und daher nicht photopolymerisierten Bereiche der bildmäßig belichteten Aufzeichnungsschichten (B) mit den erfindungsgemäß anzuwendenden organischen Entwicklerlösungsmitteln in den bekannten Sprüh-, Bürsten-, Durchlauf- und Reibewascher bei Temperaturen von 20 bis 60 °C, insbesondere 20 bis 35 °C. Dabei zeigt es sich, daß die optimalen Auswaschzeiten des erfindungsgemäßen Verfahrens kürzer sind als die der bekannten Verfahrensweisen und daß es dabei - im Gegensatz zu den bekannten Verfahrensweisen - beim überschreiten der optimalen Auswaschzeiten nicht zur sogenannten überwaschung, d.h. dem Herausbrechen von Material aus der Reliefschicht durch mechanische Einwirkung (Kantenausbruch) kommt. Unter optimaler Auswaschzeit ist dabei die Zeit zu verstehen, in der man beim Auswaschen gerade die erwünschte oder die maximale Relieftiefe erreicht. Gleichzeitig werden Reliefschichten mit stärker ausgeprägter Tiefe und sehr gutem Flankenaufbau erhalten, wobei die Oberfläche dieser Reliefschichten überraschenderweise deutlich glatter und gleichmäßiger ist als die Oberfläche von Reliefschichten, welche nach der bekannten Verfahrensweise hergestellt worden sind. Desgleichen ist die Quellung der Bildelemente deutlich geringer als bei der Verwendung üblicher organischer Entwicklerlösungsmittel. Ein zusätzlicher überraschender Vorteil des erfindungsgemäßen Verfahrens ist, daß es - selbst nach längerem Betrieb - in den Waschern und auf den hergestellten photopolymeren flexographischen Reliefdruckplatten nicht zu Ablagerungen kommt. Ein weiterer Vorteil des erfindungsgemäßen Verfahrens, welcher gar nicht hoch genug eingeschätzt werden kann, ist die Tatsache, daß für die Entwicklung nicht explosionsgeschützte Wascher verwendet werden können. Hinzu kommt noch, daß sowohl Essigsäure-(3-methoxy-n-butyl)-ester als auch Glykolsäure-n-butylester nur einen schwachen oder sehr milden Geruch haben. Somit werden in der betrieblichen Praxis weder das Bedienungspersonal des Waschers noch das Personal, welches die hergestellten photopolymeren flexographischen Reliefdruckplatten weiter handhabt, Geruchsbelästigungen ausgesetzt.

Bei der Durchführung des erfindungsgemäßen Verfahrens geht dem Entwicklungsschritt eine übliche und bekannte bildmäßige Belichtung der photopolymerisierbaren Aufzeichnungsschicht (B) mit aktinischem Licht einer Wellenlänge $\lambda$ von 230 bis 450, insbesondere 300 bis 450 nm, voraus. Hierfür geeignete Lichtquellen sind z.B. die Strahlung der Sonne, handelsübliche UV-Fluoreszensröhren, Quecksilbermittel-, -hoch- und -niederdruckstrahler, superaktinische Leuchtstoffröhren, Xenonimpulslampen, mit Metalliodiden dotierte Lampen oder Kohlebogenlampen.

Dem Entwicklungsschritt schließt sich im weiteren Ablauf des erfindungsgemäßen Verfahrens die Trocknung der photopolymeren flexographischen Reliefdruckplatten an. Vorzugsweise erfolgt diese Trocknung in üblichen und bekannten Trocknern wie Umlufttrockenschränken bei Temperaturen oberhalb der Raumtemperatur, insbesondere oberhalb 50 °C. Hierbei werden die nach dem erfindungsgemäßen Verfahren erhaltenen photopolymeren flexographischen Reliefdruckplatten so lange getrocknet, bis ihre Reliefschichten im wesentlichen die Ausgangsschichtdicken vor der Quellung durch das organische Entwicklerlösungsmittel wieder erreicht haben. Hierbei ist es von ganz besonderem Vorteil, so lange zu trocknen, bis die Reliefschichten Toleranzen von $\leq 20$ µm, insbesondere $\leq 15$ µm, erreicht haben. Hiernach weisen die in erfindungsgemäßer Verfahrensweise hergestellten photopolymeren flexographischen Reliefdruckplatten auch keinen Langzeitschrumpf mehr auf, was die Grundvoraussetzung für ihre vorzügliche Wiederverwendbarkeit ist. Die Trocknungszeiten, innerhalb derer dieses Ziel erreicht wird, sind überraschenderweise vorteilhaft kurz.

Vorteilhafterweise werden die Toleranzen der Reliefschichten separat an Volltonflächen des Formats DIN A3 anhand von 40 Meßstellen bestimmt.

Die getrockneten photopolymeren flexographischen Reliefdruckplatten können anschließend noch in Halogen enthaltenden oder liefernden Bädern halogeniert, in reduzierenden Bädern nachgewaschen und hiernach erneut getrocknet werden. Alternativ oder im Nachgang zu dieser Behandlung können die photopolymeren flexographischen Reliefdruckplatten noch mit aktinischem Licht, insbesondere Licht einer Wellenlänge $\lambda$ <250 nm, vollflächig belichtet werden.

Ein weiterer Vorteil des erfindungsgemäßen Verfahrens ist es, daß es an zahlreichen bekannten, lichtempfindlichen Aufzeichnungselementen, welche sich für die Herstellung von photopolymeren flexographischen Reliefdruckplatten eignen, mit ausgezeichnetem Erfolg ausgeführt werden kann. Solche bekannten, lichtempfindlichen Aufzeichnungselemente enthalten in der Hauptsache

A) einen dimensionsstabilen Träger und

B) mindestens eine photopolymerisierbare Aufzeichnungsschicht mit

 $b_1$) mindestens einem elastomeren Polymeren als Bindemittel,

 $b_2$) mindestens einem photopolymerisierbaren Monomeren, welches mit dem Bindemittel ($b_1$) verträglich ist und

 $b_3$) mindestens einen Photopolymerisationsinitiator

und werden von der Fachwelt auch etwas ungenau als "Flexodruckplatten" bezeichnet.

Die photopolymerisierbaren Aufzeichnungsschichten (B) dieser Flexodruckplatten können noch weitere geeignete Zusätze wie Inhibitoren der thermisch initiierten Polymerisation, Farbstoffe, Pigmente, photochrome Stoffe, Lichthofschutzmittel, Weichmacher, Antioxidantien, Antiozonantien, Mittel zur Verbesserung der Reliefstruktur, Vernetzungshilfsmittel, Flußmittel, Trennmittel, Füllmittel und/oder Verstärkerfüllstoffe in wirksamen Mengen enthalten. Hierbei können die Flexodruckplatten mehrere dieser photopolymerisierbaren Aufzeichnungsschichten (B) übereinanderliegend und haftfest miteinander verbunden enthalten, wobei diese Schichten (B) von stofflich gleicher, in etwa gleicher oder unterschiedlicher Zusammensetzung sein können. Außerdem können solche bekannten lichtempfindlichen Aufzeichnungselemente eine alkohollösliche Deckschicht (C) aus beispielsweise Polyamid aufweisen, welche der photopolymerisierbaren Aufzeichnungsschicht (B) direkt aufliegt.

Bei der Durchführung des erfindungsgemäßen Verfahrens ergeben sich besonders vorteilhaft kurze Auswaschzeiten, wenn die betreffenden bekannten lichtempfindlichen Aufzeichnungselemente eine photopolymerisierbare Aufzeichenschicht (B) aufweisen, welche als Bindemittel ($b_1$) Vinylaromat-Alkadien-Blockmischpolymerisate (Styrol-Isopren-Styrol, Styrol-Butadien-Styrol, Styrol-Isopren-Styrol/Butadien, etc.) Alkadien-Acrylnitril-Copolymerisate (Butadien-Acrylnitril), Fluorkautschuke (Vinylidenchlorid-Hexafluorpropylen-Copolymerisate), Naturkautschuke, Silikonpolymerisate, Polysulfidkautschuke oder

Ethylen-Propylen-Dien-Terpolymere enthalten.

Flexodruckplatten dieser Art sind im Handel frei erhältlich und werden beispielsweise von der Firma BASF unter den Warenzeichen oder Handelsnamen Nyloflex® FA 170, FA 284, FA 470, FAR 284, MA 275 oder FO 284, von der Firma DuPont de Nemours unter den Warenzeichen oder Handelsnamen CYREL® HOS 112, PQS 112, DRS 112 oder PLS 112, von der Firma Asahi Chemical Corp. unter dem Warenzeichen oder Handelsnamen AFP® 284, von der Firma Grace unter dem vormals der Firma Uniroyal gehörenden Warenzeichen oder Handelsnamen Flexlight® KOR 284 oder von der Firma Tokyo Okha Kogyo K.K. unter dem Warenzeichen oder Handelsnamen Elaslon® Grün 284 vertrieben.

Beispiele 1 bis 15

Die Herstellung photopolymerer flexographischer Reliefdruckplatten aus handelsüblichen Flexodruckplatten mit Hilfe des erfindungsgemäßen Verfahrens

Allgemeine Versuchsvorschrift:

Für die Beispiele 1 bis 15 wurden handelsübliche Flexodruckplatten verwendet, welche auf einem dimensionsstabilen Träger (A) eine photopolymerisierbare Aufzeichnungsschicht (B) und eine übliche und bekannte alkohollösliche Deckschicht (C) aus beispielsweise Polyamid (Makromelt® 6900 der Firma Henkel) aufwiesen.

Die Tabelle 1 gibt Auskunft über die Zusammensetzung der photopolymerisierbaren Aufzeichnungsschichten (B) der verwendeten handelsüblichen Flexodruckplatten, oder es wird deren am Markt bekannte Bezeichnung angegeben. Außerdem geht aus der Tabelle 1 die Gesamtdicke (Sollstärke) der aus diesen handelsüblichen Flexodruckplatten hergestellten photopolymeren flexographischen Reliefdruckplatten hervor. Diese Gesamtdicke setzt sich aus der Dicke des Trägers (A) und der Dicke der Reliefschicht zusammen (die Deckschicht (c) ist in den bildmäßig belichteten und entwickelten Reliefdruckplatten ja nicht mehr vorhanden) und ist für den Reprographen und den Drucker in der betrieblichen Praxis eine wichtige Kenngröße. Alle Flexodruckplatten der Beispiele 1 bis 15 wurden zunächst von ihrer Rückseite her vorbelichtet und hiernach durch ein auf die Oberfläche ihrer Deckschicht (C) aufgelegtes Testnegativ hindurch bildmäßig belichtet. Die Belichtungsbedingungen finden sich in der Tabelle 2.

Im Anschluß an die bildmäßige Belichtung wurden die Flexodruckplatten der Beispiele 1 bis 15 in einem handelsüblichen Nyloflex® F II-Bürstenrundwascher in erfindungsgemäßer Verfahrensweise ausgewaschen. Während des Auswaschens wurde ermittelt, nach welcher Zeit bei den einzelnen Flexodruckplatten eine Relieftiefe von 750 $\mu$m, 1000 $\mu$m oder, sofern dies von der Dicke her möglich war, 3000 $\mu$m erreicht wurde. Die Tabelle 3 gibt einen Überblick über die jeweils verwendeten organischen Entwicklerlösungsmittel und die bei der Entwicklung erzielten Auswaschzeiten.

Die in der Tabelle 3 zusammengestellten Werte zeigen, daß die erfindungsgemäß anzuwendenden organischen Entwicklerlösungsmittel bei einer Vielzahl unterschiedlicher Flexodruckplatten vorzügliche Entwicklungsergebnisse in kurzer Zeit lieferten. Auch kam es bei der Entwicklung der Flexodruckplatten der Beispiele 1 bis 15 bei 30 °C zu keiner Geruchsbelästigung, welche eine zusätzliche Belüftung des Arbeitsraumes notwendig gemacht hätte.

Die in erfindungsgemäßer Verfahrensweise hergestellten photopolymeren flexographischen Reliefdruckplatten bzw. deren Reliefschichten waren nach dem Entwicklungsvorgang etwas angequollen. Die Tabelle 4 gibt einen überblick über den betreffenden Dickenzuwachs der photopolymeren flexographischen Reliefdruckplatten. Die photopolymeren fleoxgraphischen Reliefdruckplatten wurden deshalb - wie es auf dem hier in Rede stehenden technischen Gebiet üblich ist - getrocknet. Hierzu wurde ein Umlufttrockenschrank mit einer Lufttemperatur von 60 °C verwendet.

Während der Trocknung wurde nach einer halben Stunde, einer Stunde und zwei Stunden überprüft, inwieweit der Schichtdickenzuwachs, welcher durch den Entwicklungsvorgang hervorgerufen worden war, abgenommen hatte. Die betreffenden Werte sind gleichfalls in der Tabelle 4 zusammengestellt.

Wie aus der Tabelle 4 hervorgeht, genügte bei den dünnen, in erfindungsgemäßer Verfahrensweise hergestellten photopolymeren flexographischen Reliefdruckplatten und bei denjenigen mittlerer Dicke eine Stunde Trocknungszeit, um die Ausgangsschichtdicke vor dem Entwicklungsvorgang wieder oder fast wieder zu erreichen (vgl. die Beispiele 1 und 2, 4 bis 13 und 15). Nach dieser Zeit wiesen die photopolymeren flexographischen Reliefdruckplatten der Beispiele 1 und 2, 4 bis 13 und 15 bereits Toleranzen im Bereich unterhalb von 20 $\mu$m auf. Nach zweistündiger Trocknung Zeigten einige dieser photopolymeren flexographischen Reliefdruckplatten eine geringe Schrumpfung, welche auf die Extraktion niedermolekularer Bestandteile aus ihren bildmäßig belichteten Aufzeichnungsschichten (B) durch die

erfindungsgemäß zu verwendenden Entwicklerlösungsmittel zurückzuführen war (vgl. die Tabelle 4, Beispiele 1, 2, 5, 7 bis 11 und 13).

Nach diesen zwei Stunden hatten die photopolymeren flexographischen Reliefdruckplatten der Beispiele 1 und 2, 4 bis 13 und 15 Toleranzen von ≦ 20 µm erreicht. Sie waren daher nach dem Aufspannen auf Druckzylinder vorzüglich für den Flexoendlosdruck geeignet und lieferten wegen der auf das erfindungsgemäße Verfahren zurückgehenden vorzüglichen Ausbildung ihrer Reliefschichten exzellente Druckerzeugnisse in besonders hoher Auflage. Nach dem Druckvorgang konnten die in erfindungsgemäßer Verfahrensweise hergestellten photopolymeren flexographischen Reliefdruckplatten der genannten Beispiele mehrere Monate lang gelagert werden, ohne daß es hierbei zu einer weiteren Änderung ihrer Dimensionen durch Langzeitschrumpf gekommen wäre. Nach dieser Langzeitlagerung lieferten die betreffenden photopolymeren flexographischen Reliefdruckplatten nach wie vor exzellente Druckerzeugnisse, welche von den Erstauflagen nicht zu unterscheiden waren.

Was die Dicken, der in erfindungsgemäßer Verfahrensweise hergestellten photopolymeren flexographischen Reliefdruckplatten der Beispiele 3 und 14 betraf, waren nach zweistündiger Trocknungszeit bei 60 °C die Ausgangsschichtdicke und Toleranzen von ≦20 µm erreicht, so daß die betreffenden photopolymeren flexographischen Reliefdruckplatten direkt für den Kartonagendruck verwendet werden konnten. Hierbei erwiesen sie sich wegen ihres vorzüglich ausgebildeten Reliefs und ihrer Dimensionsstabilität als ausgesprochen auflagenstabil und detailgetreu.

Die anhand der bildmäßig belichteten und entwickelten Flexodruckplatten der Beispiele 1 bis 15 ermittelten Trocknungszeiten welche für das Erreichen von Toleranzen ≦20 µm, insbesondere ≦15 µm notwendig waren, wurden zur Sicherheit mit den entsprechenden Trocknungszeiten verglichen, welche separat mit Hilfe vollflächig belichteter und mit den betreffenden Entwicklerlösungsmitteln behandelter Flexodruckplatten des Formats DIN A3 anhand von jeweils 40 Meßstellen ermittelt worden waren. Der Vergleich ergab eine innerhalb der Fehlergrenzen liegende Übereinstimmung.

Insgesamt untermauern die Ergebnisse der Beispiele 1 bis 15, daß mit Hilfe des erfindungsgemäßen Verfahrens die unterschiedlichsten Flexodruckplatten rasch und zuverlässig verarbeitet werden können, was für die betriebliche Praxis der Reprographie essentiell ist.

Außerdem warfen die erfindungsgemäß zu verwendenden organischen Entwicklerlösungsmittel keine schwerwiegenden sicherheitstechnischen und arbeitshygienischen Probleme auf. So konnten insbesondere die bei der Durchführung der Beispiele 1 bis 13 verbrauchten organischen Entwicklerlösungsmittel problemlos durch Destillation unter Normaldruck wiederaufgearbeitet und hiernach wiederverwendet oder problemlos entsorgt werden, was ein zusätzlicher Vorteil des erfindungsgemäßen Verfahrens ist.

Tabelle 1: Zusammensetzung der photopolymerisierbaren Aufzeichnungsschichten (B) der Flexodruckplatten oder deren am Markt bekannten Bezeichnungen sowie die Dicke d der hieraus hergestellten photopolymeren flexographischen Reliefdruckplatten

| Beispiel Nr. | Zusammensetzung der Aufzeichnungsschicht (B) oder die marktgängige Bezeichnung | [Gew.-%] | Dicke d der Reliefdruckplatte [ohne Deckschicht (C)] µm |
|---|---|---|---|
| 1 | Dreiblockkautschuk aus Styrol-Isopren-Styrol/Butadien | [82,616] | 1730 ± 15 |
| | Weißöl S 200 | [ 5,00] | |
| | α-Methylstyrol (10 Gew.-%)/ p-Methylstyrol (90 Gew.-%)-Cooligomer (Piccotex® 100) | [ 5,00] | |
| | Hexan-1,6-diol-diacrylat | [ 3,33] | |
| | Hexan-1,6-diol-dimethacrylat | [ 1,65] | |
| | Benzildimethylacetal | [ 1,20] | |
| | 2,6-Di-tert.-butyl-p-kresol | [ 0,198] | |
| | Sudantiefschwarz BB | [ 0,006] | |
| | Ozonschutzwachs Antilux® 550 der Fa. Rheinchemie | [ 1,00] | |
| 2 | wie Beispiel 1 | | 2840 ± 15 |

Tabelle 1: - Fortsetzung -

| Beispiel Nr. | Zusammensetzung der Aufzeichnungsschicht (B) oder die marktgängige Bezeichnung | [Gew.-%] | Dicke d der Reliefdruckplatte [ohne Deckschicht (C)] µm |
|---|---|---|---|
| 3 | Dreiblockkautschuk des Beispiels 1 | [68,098] | 4730 ± 15 |
| | Weißöl des Beispiels 1 | [13,00] | |
| | Piccotex® 100 des Beispiels 1 | [ 5,00] | |
| | Acrylat des Beispiels 1 | [ 6,70] | |
| | Methacrylat des Beispiels 1 | [ 3,30] | |
| | Benzildimethylacetal | [ 1,20] | |
| | 2,6-Di-tert.-butyl-p-kresol | [ 0,70] | |
| | Farbstoff des Beispiels 1 | [ 0,002] | |
| | Ozonschutzwachs des Beispiels 1 der Fa. Rheinchemie | [ 2,00] | |
| 4 | Dreiblockkautschuk des Beispiels 1 | [68,794] | 2860 ± 15 |
| | Chlorparaffin (Hordaflex® LC 50 der Fa. Hoechst) | [13,00] | |
| | 2-Ethylhexylacrylat | [ 2,50] | |
| | Piccotex® 100 des Beispiels 1 | [ 2,50] | |
| | Acrylat des Beispiels 1 | [ 6,70] | |
| | Methacrylat des Beispiels 1 | [ 3,30] | |
| | Benzildimethylacetal | [ 1,20] | |
| | 2,6-Di-tert.-butyl-p-kresol | [ 1,00] | |
| | Farbstoff des Beispiels 1 | [ 0,006] | |
| | Ozonschutzwachs des Beispiels 1 | [1,00] | |

Tabelle 1: - Fortsetzung -

| Beispiel Nr. | Zusammensetzung der Aufzeichnungsschicht (B) oder die marktgängige Bezeichnung | [Gew.-%] | Dicke d der Reliefdruckplatte [ohne Deckschicht (C)] µm |
|---|---|---|---|
| 5 | Dreiblockkautschuk des Beispiels 1 | [80,1142] | 2760 ± 15 |
| | Piccotex® 100 des Beispiels 1 | [ 7,5] | |
| | Acrylat des Beispiels 1 | [ 7,32] | |
| | Methacrylat des Beispiels 1 | [ 3,66] | |
| | Benzildimethylacetal | [ 1,20] | |
| | 2,6-Di-tert.-butyl-p-kresol | [ 0,198] | |
| | Farbstoff des Beispiels 1 | [ 0,0078] | |
| 6 | Butadien-Acrylnitril-Kautschuk | [65,292] | 2875 ± 15 |
| | Phthalsäuredioctylester | [23,193] | |
| | Acrylat des Beispiels 1 | [ 3,63] | |
| | Methacrylat des Beispiels 1 | [ 3,63] | |
| | Trimethylolpropantriacrylat | [ 2,42] | |
| | Benzildimethylacetal | [ 0,968] | |
| | 2,6-Di-tert.-butyl-p-kresol | [ 0,447] | |
| | Farbstoff des Beispiels 1 | [0,42] | |

Tabelle 1: - Fortsetzung -

| Beispiel Nr. | Zusammensetzung der Aufzeichnungsschicht (B) oder die marktgängige Bezeichnung | [Gew.-%] | Dicke d der Reliefdruckplatte [ohne Deckschicht (C)] µm |
|---|---|---|---|
| 7 | Cyrel HOS 112 | | 2850 ± 15 |
| 8 | Cyrel PQS 112 | | 2830 ± 15 |
| 9 | Cyrel DRS 112 | | 2810 ± 15 |
| 10 | Cyrel PLS 112 | | 2830 ± 15 |
| 11 | Styrol-Butadien-Vierblockautschuk mit 47 Gew.-% Styrol und 43 Gew.-% Butadien | [62,98] | 2820 ± 15 |
| | niedermolekulares Polybutadien eines zahlenmittleren Molekulargewichts $\bar{M}_n$ von 2800 | [30,30] | |
| | Fumarsäure-di-(2-ethylhexyl)-ester | [ 4,50] | |
| | Benzildimethylacetal | [ 2,00] | |
| | 2,6-Di-tert.-butyl-p-kresol | [ 0,18] | |
| | Tris-(i-octylphenyl)-phosphit | [0,04] | |
| 12 | Styrol-Butadien-Blockkautschuk mit 35 Gew.-% Styrol und 65 Gew.-% Butadien, wobei der Butadienanteil die folgenden Isomerenanteile aufweist: 1,2 - 10 %; 1,4-cis - 23 % und 1,4-trans - 32 % | [63,2] | 2880 ± 15 |
| | Polybutadienöl | [34] | |
| | Trimethylolpropantriacrylat | [2,1] | |
| | Benzildimethylacetal | [0,6] | |
| | 2,6-Di-tert.-butyl-p-kresol | [0,1] | |

Tabelle 1: - Fortsetzung -

| Beispiel Nr. | Zusammensetzung der Aufzeichnungsschicht (B) oder die marktgängige Bezeichnung | [Gew.-%] | Dicke d der Reliefdruckplatte [ohne Deckschicht (C)] µm |
|---|---|---|---|
| 13 | Styrol-Isopren-Kautschuk eines Styrolgehaltes von 13 % | [90,8] | 2890 ± 15 |
| | Acrylat des Beispiels 1 | [3,3] | |
| | Methacrylat des Beispiels 1 | [2,1] | |
| | Benzildimethylacetal | [1,7] | |
| | 2,6-Di-tert.-butyl-p-kresol | [1,7] | |
| | 1,2-Bis-(3',5'-di-tert.-butyl-4'-hydroxy-phen-1'-yl)-ethan | [0,1] | |
| | n-Paraffinwachs (Ozonschutzwachs) | [0,3] | |
| 14 | wie Beispiel 3 | | |
| 15 | wie Beispiel 7 | | |

Tabelle 2: Die Belichtungsbedingungen der Beispiele 1 bis 15

| Beispiel Nr. | Vorbelichtung mit aktinischem Licht (s) | bildmäßige Belichtung mit aktinischem Licht (min) |
|---|---|---|
| 1 | 25 | 10 |
| 2 | 65 | 10 |
| 3 | 40 | 14 |
| 4 | 80 | 10 |
| 5 | 15 | 10 |
| 6 | 80 | 12 |
| 7 | 60 | 9 |
| 8 | 65 | 9 |
| 9 | 80 | 9 |
| 10 | 80 | 9 |
| 11 | 110 | 18 |
| 12 | 240 | 28 |
| 13 | 120 | 15 |
| 14 | 40 | 14 |
| 15 | 60 | 9 |

Tabelle 3: Die Entwicklung der bildmäßig belichteten Flexodruckplatten der Beispiele 1 bis 15 nach dem erfindungsgemäßen Verfahren

| Beispiel Nr. | organisches Entwicklerlösungsmittel Zusammensetzung | [Vol.-%] | Entwicklung bei 20°C: Entwicklungszeit (min) für Relieftiefe von 750 µm | 1000 µm | 3000 µm | Entwicklung bei 30°C: Entwicklungszeit (min) für Relieftiefe von 750 µm | 1000 µm | 3000 µm |
|---|---|---|---|---|---|---|---|---|
| 1 | Butoxyl®a)<br>n-Butanol | [80]<br>[20] | 5,6 | 8 | - | 4 | 7,2 | - |
| 2 | Butoxyl®a)<br>n-Butanol | [80]<br>[20] | 5,6 | 8 | - | 4 | 7,2 | - |
| 3 | Butoxyl®a)<br>2-Ethylhexanol | [80]<br>[20] | - | - | 14 | - | - | 11 |
| 4 | Butoxyl®a)<br>n-Pentanol | [80]<br>[20] | 5,6 | 8 | - | 4 | 7,2 | - |
| 5 | Butoxyl®a)<br>2-Ethylhexanol | [80]<br>[20] | 5 | - | - | 4 | - | - |
| 6 | Butoxyl®a)<br>2-Ethylhexanol | [80]<br>[20] | 7 | 9,6 | - | 5,6 | 8 | - |
| 7 | Butoxyl®a)<br>2-Ethylhexanol | [80]<br>[20] | 5,6 | 7 | - | 4 | 5,6 | - |

Tabelle 3: Die Entwicklung der bildmäßig belichteten Flexodruckplatten der Beispiele 1 bis 15 nach dem erfindungsgemäßen Verfahren

| Beispiel Nr. | organisches Entwicklerlösungsmittel Zusammensetzung | [Vol.-%] | Entwicklung bei 20°C: Entwicklungszeit (min) für Relieftiefe von 750 µm | 1000 µm | 3000 µm | Entwicklung bei 30°C: Entwicklungszeit (min) für Relieftiefe von 750 µm | 1000 µm | 3000 µm |
|---|---|---|---|---|---|---|---|---|
| 8 | Butoxyl®a)<br>n-Pentanol | [80]<br>[20] | 15 | 21 | - | 12 | 18 | - |
| 9 | Butoxyl®a)<br>2-Ethylhexanol | [80]<br>[20] | 7 | 9,6 | - | 5,6 | 8 | - |
| 10 | Butoxyl®a)<br>n-Pentanol | [80]<br>[20] | 6 | 9 | - | 5 | 6,5 | - |
| 11 | Butoxyl®a)<br>2-Ethylhexanol | [80]<br>[20] | 5 | 6,5 | - | 3 | 5 | - |
| 12 | Butoxyl®a)<br>2-Ethylhexanol | [80]<br>[20] | 5 | 7 | - | 4 | 5,6 | - |
| 13 | Butoxyl®a)<br>2-Ethylhexanol | [80]<br>[20] | 13 | 20 | - | 11 | 17 | - |

Tabelle 3: Die Entwicklung der bildmäßig belichteten Flexodruckplatten der Beispiele 1 bis 15 nach dem erfindungsgemäßen Verfahren

| Beispiel Nr. | organisches Entwicklerlösungsmittel Zusammensetzung [Vol.-%] | Entwicklung bei 20°C: Entwicklungszeit (min) für Relieftiefe von | | | Entwicklung bei 30°C: Entwicklungszeit (min) für Relieftiefe von | | |
|---|---|---|---|---|---|---|---|
| | | 750 µm | 1000 µm | 3000 µm | 750 µm | 1000 µm | 3000 µm |
| 14 | Polysolvan® O[b] [100][c] | - | 16 | 22 | - | 13 | 18 |
| 15 | Polysolvan® O[b] [100][c] | 16 | 20 | - | 12 | 16 | - |

a) eingetragenes Warenzeichen der Fa. Hoechst AG, Essigsäure-(3-methoxy-n-butyl)-ester
b) eingetragenes Warenzeichen der Fa. Hoechst AG, Glykolsäure-n-butylester
c) die Deckschicht (C) der Flexodruckplatten wurden vor der eigentlichen Entwicklung mit Polysolvan® O mit n-Butanol weggewaschen

Tabelle 4: Quellungs- und Trocknungsverhalten der in erfindungsgemäßer Verfahrensweise hergestellten photopolymeren flexographischen Reliefdruckplatten der Beispiele 1 bis 15

| Beispiel Nr. | Dicke d und Dickenzuwachs Δd der Reliefdruckplatten in µm nach dem Belichten (=Ausgangs-schichtdicke) | | der Ent-wicklung | | 1/2stündiger Trocknung bei 60°C | | 1stündiger Trocknung bei 60°C | | 2stündiger Trocknung bei 60°C | |
|---|---|---|---|---|---|---|---|---|---|---|
| | d | Δd | d | Δd | d | Δd | d | Δd | d | Δd |
| 1 | 1730 | ± 0 | 1810 | + 80 | 1760 | + 30 | 1740 | + 10 | 1710 | - 10 |
| 2 | 2840 | ± 0 | 2845 | + 55 | 2865 | + 25 | 2845 | + 5 | 2835 | - 5 |
| 3 | 4730 | ± 0 | 4860 | +130 | 4790 | + 60 | 4765 | + 35 | 4745 | + 15 |
| 4 | 2860 | ± 0 | 2940 | + 85 | 2880 | + 20 | 2870 | + 10 | 2860 | ± 0 |
| 5 | 2760 | ± 0 | 2800 | + 40 | 2770 | + 10 | 2765 | - 5 | 2745 | - 15 |
| 6 | 2875 | ± 0 | 2975 | +100 | 2905 | + 40 | 2890 | + 15 | 2885 | + 10 |
| 7 | 2850 | ± 0 | 2960 | +110 | 2895 | + 45 | 2870 | + 20 | 2845 | - 5 |
| 8 | 2830 | ± 0 | 2860 | + 30 | 2850 | + 20 | 2840 | + 10 | 2825 | - 5 |
| 9 | 2810 | ± 0 | 2890 | + 80 | 2845 | + 35 | 2815 | + 5 | 2795 | - 15 |
| 10 | 2830 | ± 0 | 2920 | + 90 | 2870 | + 40 | 2830 | ± 0 | 2820 | - 10 |
| 11 | 2820 | ± 0 | 2930 | +110 | 2860 | + 40 | 2820 | ± 0 | 2795 | - 25 |
| 12 | 2880 | ± 0 | 2970 | + 90 | 2900 | + 20 | 2890 | + 10 | 2865 | ± 0 |
| 13 | 2890 | ± 0 | 2935 | + 45 | 2915 | + 25 | 2900 | - 10 | 2890 | - 25 |
| 14 | 4730 | ± 0 | 4820 | + 90 | 4780 | + 50 | 4770 | + 40 | 4750 | + 20 |
| 15 | 2850 | ± 0 | 2925 | + 75 | 2890 | + 40 | 2865 | + 15 | 2850 | ± 0 |

Vergleichsversuche V1 bis V13

Die Herstellung photopolymerer flexographischer Reliefdruckplatten aus handelsüblichen Flexodruckplatten mit Hilfe eines bekannten Verfahrens.

Allgemeine Versuchsvorschrift:

Die Beispiele 1 bis 13 wurden wiederholt, nur daß anstelle des erfindungsgemäß zu verwendenden Essigsäure-(3-methoxy-n-butyl)-esters Essigsäure-(2-butoxyethyl)-ester verwendet wurde. Abgesehen davon, daß bei den Vergleichsversuchen 1 bis 13 die Auswasch- und die Trocknungszeiten im Schnitt um den Faktor 1,5 länger waren als die entsprechenden Zeiten der Beispiele 1 bis 15, mußten hierbei auch noch besondere Vorsichtsmaßnahmen ergriffen werden, damit das Bedienungspersonal der Wascher nicht mit dem Ester in Berührung kam.

## Patentansprüche

**1.** Verfahren zur Herstellung einer photopolymeren flexographischen Reliefdruckplatte aus einem lichtempfindlichen Aufzeichnungselement, welches
A) einen dimensionsstabilen Träger und
B) mindestens eine photopolymerisierbare Aufzeichnungsschicht mit
$b_1$) mindestens einem elastomeren Polymeren als Bindemittel,
$b_2$) mindestens einem photopolymerisierbaren Monomeren, welches mit dem Bindemittel ($b_1$) verträglich ist, und
$b_3$) mindestens einem Photopolymerisationsinitiator
enthält, durch
(1) bildmäßiges Belichten der photopolymerisierbaren Aufzeichnungsschicht (B) mit aktinischem Licht und
(2) Auswaschen (Entwickeln) der nicht belichteten und daher nicht photopolymerisierten Bereiche der bildmäßig belichteten Aufzeichnungsschicht (B) mit einem organischen Entwicklerlösungsmittel unter Bildung einer Reliefschicht,
dadurch gekennzeichnet, daß das organische Entwicklerlösungsmittel Essigsäure-(3-methoxy-n-butyl)-ester und/oder Glykolsäure-n-butylester enthält oder hieraus besteht.

**2.** Das Verfahren nach Anspruch 1, dadurch gekennzeichnet, daß das organische Entwicklerlösungsmittel mindestens einen Alkohol enthält.

**3.** Das Verfahren nach Anspruch 2, dadurch gekennzeichnet, daß der Alkohol in einem Anteil von 0,1 bis 30 Vol.-% in dem organischen Entwicklerlösungsmittel enthalten ist.

**4.** Das Verfahren nach Anspruch 2 oder 3, dadurch gekennzeichnet, daß der Siedepunkt oder der Siedebereich des Alkohols dem Siedepunkt oder Siedebereich des organischen Entwicklerlösungsmittels angepaßt ist.